**Europäisches Patentamt**

**European Patent Office**

**Office européen des brevets**

(11) Numéro de publication : **0 495 699 B1**

## (12) FASCICULE DE BREVET EUROPEEN

(45) Date de publication du fascicule du brevet :
**21.06.95 Bulletin 95/25**

(51) Int. Cl.⁶ : **H03L 7/02, H05B 6/06**

(21) Numéro de dépôt : **92400065.6**

(22) Date de dépôt : **10.01.92**

(54) **Générateur de chauffage par haute fréquence.**

(30) Priorité : **18.01.91 FR 9100572**

(43) Date de publication de la demande :
**22.07.92 Bulletin 92/30**

(45) Mention de la délivrance du brevet :
**21.06.95 Bulletin 95/25**

(84) Etats contractants désignés :
**CH DE ES FR GB IT LI**

(56) Documents cités :
**EP-A- 0 157 534
EP-A- 0 238 122
EP-A- 0 405 611
PATENT ABSTRACTS OF JAPAN vol. 14, no.
151 (E-906)22 Mars 1990**

(73) Titulaire : **THOMSON TUBES
ELECTRONIQUES
38, rue Vauthier
F-92100 Boulogne-Billancourt (FR)**

(72) Inventeur : **Bel, Claude
THOMSON-CSF,
SCPI,
Cédex 67
F-92045 Paris la Défense (FR)**

(74) Mandataire : **Guérin, Michel et al
THOMSON-CSF
SCPI
B.P. 329
50, rue Jean-Pierre Timbaud
F-92402 Courbevoie Cédex (FR)**

## Description

La présente invention se rapporte aux générateurs de chauffage par haute fréquence. Ces générateurs peuvent être utilisés notamment dans des dispositifs de chauffage par induction électromagnétique, par pertes diélectriques ou par plasma.

De tels générateurs comportent généralement un circuit résonant couplé électromagnétiquement à une pièce à chauffer, connecté en sortie d'au moins un tube électronique monté en auto-oscillateur (voir par exemple le document EP-A 0 238 122).

Le chauffage par induction électromagnétique consiste à produire l'échauffement d'une pièce conductrice par la circulation de courants induits par un champ magnétique. Ce moyen permet de chauffer la pièce dans sa masse sans contact direct avec la source d'énergie. La pièce à chauffer (ou induit) est entourée d'au moins une boucle de circulation de courant (ou inducteur). Les fréquences de travail du générateur sont comprises entre quelques dizaines de kilohertz et quelques mégahertz. Les puissances nécessaires varient entre quelques kilowatts à plus d'un mégawatt. Le chauffage par induction électromagnétique est utilisé largement dans l'industrie et dans le domaine scientifique. Dans l'industrie, il est utilisé notamment en métallurgie pour affiner des métaux, pour traiter thermiquement des pièces métalliques ou pour produire des tubes soudés en continu.

Le chauffage par pertes diélectriques consiste à produire l'échauffement d'une pièce isolante en provoquant des pertes dans sa masse, à partir d'un champ électrique alternatif. La pièce à chauffer est un isolant médiocre. Elle est placée entre deux armatures conductrices alimentées par une source alternative. On crée un condensateur dont le diélectrique est la pièce à chauffer. Les générateurs utilisés ont généralement des fréquences de travail plus élevées que celles des générateurs de chauffage par induction électromagnétique. Elles peuvent être comprises entre quelques dizaines de mégahertz et quelques gigahertz. Ce mode de chauffage s'utilise dans l'industrie du bois pour le séchage ou le collage, dans l'industrie textile ou dans la fabrication ou le façonnage de matières plastiques.

Le chauffage par plasma consiste à ioniser un milieu gazeux pour le transformer en plasma. L'énergie cinétique des électrons se transforme en chaleur. Il se produit une élévation considérable de température. La pièce à chauffer est placée dans le plasma. La transformation du milieu gazeux en plasma est obtenue par l'émission d'une antenne. Les fréquences de travail du générateur sont comprises entre 1 mégahertz et quelques dizaines de mégahertz. Le mode de chauffage est utilisé dans de nombreuses applications industrielles telle que la fusion de produits réfractaires, la synthèse chimique etc...

Les performances des générateurs de chauffage par haute fréquence sont optimales si l'impédance de charge vue par le tube électronique est adaptée à tout instant. Le circuit résonant couplé électromagnétiquement à la pièce à chauffer est équivalent soit à un circuit R,L,C parallèle, soit à un circuit R,L,C série. Le coefficient de surtension Q du circuit résonant est élevé et le désaccord est facile au voisinage de la fréquence de résonance. Pour que l'impédance de charge vue du tube soit adaptée, il faut qu'elle soit réelle et que son module ait une valeur optimale pour le tube. L'impédance de charge est essentiellement variable car elle dépend des caractéristiques des éléments constituant le circuit résonant et notamment du matériau de la pièce à chauffer, de leurs dimensions et de leur position relative. Cette position est importante surtout si la pièce à chauffer est en mouvement, par exemple si c'est une plaque de tôle chauffée par induction que l'on roule et que l'on soude en continu.

La plupart des caractéristiques varient aussi avec la température et le temps. La variation de l'impédance entraîne une variation de la fréquence de résonance du circuit résonant. Les performances des tubes électroniques sont affectées par ces variations. Leur rendement se dégrade. Le tube étant utilisé dans un montage auto-oscillateur, sa fréquence de travail est influencée par la fréquence de résonance du circuit résonant sans pour autant être identique. La variation de la fréquence de résonance peut entraîner un décrochage de l'oscillateur qui refuse alors d'osciller. Tous ces désaccords rendent nécessaire une surexcitation du tube ce qui peut lui nuire.

Pour adapter l'impédance de charge vue du tube, on peut insérer des éléments commutables dans un transformateur d'adaptation intercalé entre le tube oscillateur et le circuit résonant. Cette adaptation se fait avant le début du chauffage en fonction de l'impédance supposée qu'aura la charge.

On peut aussi intercaler un circuit comprenant des inductances et des capacités variables entre le circuit résonant et le tube oscillateur. Ces éléments variables sont asservis en permanence pour caler la fréquence de résonance du circuit résonant sur la fréquence de travail choisie du générateur et pour que le module de l'impédance garde en permanence sa valeur optimale. Les asservissements sont souvent électromécaniques. Ce système est employé lorsque des puissances importantes sont mises en jeu. Les éléments utilisés sont onéreux car ils sont dimensionnés pour recevoir des courants importants. Ils sont encombrants et introduisent des pertes par effet Joule non négligeables.

La présente invention vise à remédier à ces inconvénients. Elle propose un générateur de chauffage par haute fréquence comprenant un amplificateur à au moins une tétrode, dont la sortie est connectée à un circuit résonant couplé électromagnétiquement à une pièce à chauffer et dont la fréquence de travail est adaptée en permanence à la fréquence du circuit résonant.

Un oscillateur à fréquence commandée fournit un signal haute fréquence destiné à être transmis à l'entrée de l'amplificateur. Un moyen est prévu pour mesurer le déphasage entre le courant fourni au circuit résonant et la tension à ses bornes et pour modifier la fréquence de l'oscillateur en fonction du déphasage.

Le moyen pour mesurer le déphasage est connecté pour recevoir sur une entrée la tension sur la grille de commande de la tétrode et sur une autre entrée la tension aux bornes du circuit résonant.

Le moyen pour mesurer le déphasage comprend, de préférence, un convertisseur phase-tension fournissant une tension proportionnelle à la différence de phase $\varnothing$ entre les tensions appliquées à ses entrées.

De préférence, le convertisseur phase-tension comprend en entrée, un déphaseur pour ajouter ¶/2 à la différence de phase $\varnothing$ . Ce déphaseur fournit deux tensions dont la différence de phase est $\varnothing$ + ¶/2.

De préférence un circuit amplificateur écrêteur reçoit les deux tensions déphasées de $\varnothing$ + ¶/2 et fournit deux tensions en créneaux logiques représentant les demies périodes positives des tensions déphasées de $\varnothing$ + ¶/2, à une fonction logique qui produit une tension correspondant à la somme logique des tensions en créneaux.

Un amplificateur différentiel reçoit sur une entrée la tension de sortie de la fonction logique après intégration, sur une autre entrée une tension constante et fournit la tension proportionnelle à la différence de phase $\varnothing$.

Le moyen pour modifier la fréquence de l'oscillateur comporte, de préférence, un sommateur qui reçoit d'une part la tension proportionnelle à la différence de phase $\varnothing$ et d'autre part une tension de réglage de consigne, et qui fournit une tension de commande à l'oscillateur.

Un élément de réglage de gain est, de préférence, connecté entre la sortie de l'oscillateur et l'entrée de l'amplificateur. Une boucle d'asservissement reçoit la tension aux bornes du circuit résonant et agit sur le gain de l'élément de réglage de manière à maintenir l'amplitude de la tension aux bornes du circuit résonant à une valeur choisie constante. La boucle d'asservissement comporte, de préférence, un amplificateur opérationel recevant sur une entrée la tension aux bornes du circuit résonant et sur une autre entrée une tension de consigne fonction de la tension à obtenir aux bornes du circuit résonant.

De préférence, l'élément de réglage de gain comporte un diviseur capacitif dont une branche est une diode varicap.

De préférence, un préamplificateur est inséré entre l'élément de réglage de gain et l'entrée de l'amplificateur à tube électronique.

De préférence, un transformateur d'impédance est connecté entre le tube électronique et le circuit résonant.

Lorsque le générateur de chauffage chauffe par induction, le circuit résonant comprend au moins une boucle de circulation de courant autour de la pièce à chauffer.

Lorsque le générateur de chauffage chauffe par pertes diélectriques, le circuit résonant comprend des armatures de condensateur entre lesquelles est placée la pièce à chauffer.

Lorsque le générateur de chauffage chauffe par plasma, le circuit résonant comprend une antenne d'émission excitant le plasma.

La présente invention sera mieux comprise et d'autres caractéristiques et avantages apparaîtront à la lecture de la description suivante, illustrée par les figures annexées qui représentent :
- la figure 1 : un schéma électrique d'un générateur selon l'invention ;
- la figure 2 : un schéma électrique du convertisseur phase-tension;
- la figure 3a : les tensions a et b, en fonction du temps, appliquées à l'entrée du déphaseur contenu dans le convertisseur phase-tension;
- la figure 3b : les tensions c et d, en fonction du temps, présentes en sortie du déphaseur ;
- la figure 3c : les tensions e et f, en fonction du temps, ces tensions en créneaux correspondant aux demies périodes positives des tensions c et d;
- la figure 3d : la tension g, en fonction du temps, présente en sortie de la fonction logique contenue dans le convertisseur phase-tension;
- la figure 4 : un schéma électrique de l'élément de réglage de gain et de la boucle d'asservissement;
- la figure 5 : un schéma électrique de l'atténuateur variable contenu dans l'élément de réglage de gain.

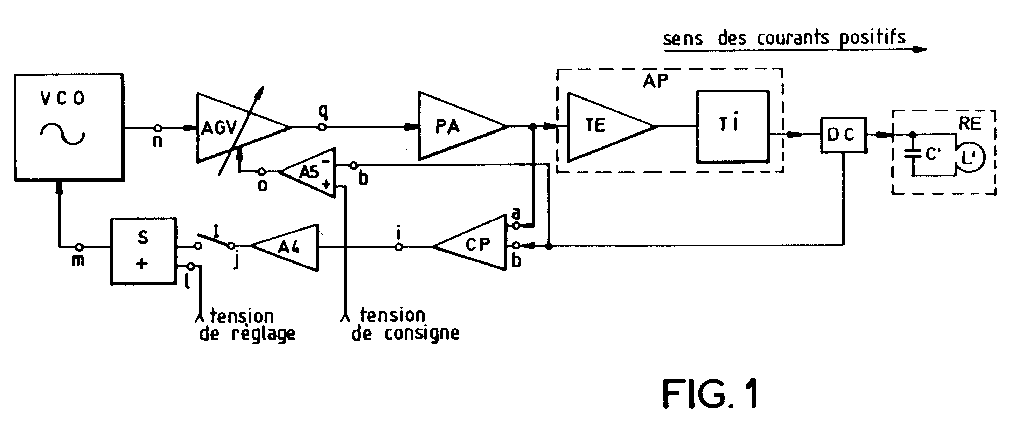

Sur les figures, on a placé des indices alphabétiques qui représentent à la fois les entrées ou les sorties des opérateurs et les tensions correspondantes, référencées par rapport à la masse. Sur la figure 1, le sens du courant positif est mentionné en sortie de l'amplificateur AP.

La figure 1 représente un schéma électrique d'un générateur de chauffage haute fréquence selon l'invention. Le générateur comprend un amplificateur AP à tube électronique dont la sortie alimente un circuit résonant RE couplé électromagnétiquement à une pièce à chauffer. Le circuit résonant est équivalent électriquement à un circuit de type R,L,C en parallèle ou en série. Dans l'exemple décrit, le générateur est un générateur de chauffage par induction. Il pourrait être un générateur de chauffage par pertes diélectriques ou par plasma. Il y aurait une différence au niveau du circuit résonant mais ce circuit serait toujours équivalent électriquement à un circuit de type R,L,C.

Le circuit résonant RE, dans l'exemple décrit, comporte au moins une boucle inductrice L′ entourant la pièce à chauffer et au moins une capacité C′ placée au plus près de la boucle inductrice L′. La partie réelle de l'impédance équivalente représentant la boucle inductrice L′ couplée à la pièce à chauffer correspond à une résistance R′ (non représentée). En plaçant la capacité C′ au plus près de la boucle inductrice L′, on limite les pertes par effet Joule dans les liaisons entre le générateur et la boucle inductrice L′.

Le circuit résonant RE représenté est équivalent à un circuit parallèle. Ce n'est qu'un exemple, il pourrait être équivalent à un circuit série.

Un oscillateur à fréquence commandée VCO fournit un signal haute fréquence à l'entrée de l'amplificateur AP.

Le générateur comporte aussi un moyen pour mesurer le déphasage entre le courant fourni par le tube électronique au circuit résonant RE et la tension à ses bornes et pour modifier la fréquence de l'oscillateur VCO en fonction de ce déphasage.

Un élément de réglage de gain AGV est inséré entre l'oscillateur à fréquence commandée VCO et l'amplificateur AP et une boucle d'asservissement commandée par une tension de consigne permet de maintenir sensiblement constante, à une valeur choisie, l'amplitude de la tension aux bornes du circuit résonant. La tension de consigne est fonction de la puissance à fournir dans la pièce à chauffer.

On insère aussi au moins un préamplificateur PA entre la sortie de l'élément de réglage de gain AGV et l'entrée de l'amplificateur AP à tube électronique. A forte puissance un préamplificateur à transistors suffit. Pour des applications de très forte puissance, on peut être amené à connecter un préamplificateur supplémentaire, à tube électronique, en sortie du préamplificateur à transistors. L'adaptation entre le préamplificateur supplémentaire et le tube électronique est alors à large bande.

L'amplificateur AP de puissance comprend au moins un tube électronique. Ce tube est de préférence une tétrode TE à fort gain et haut rendement. Il est utilisé dans un montage cathode à la masse. Un transformateur d'impédance TI est connecté entre l'anode du tube et le circuit résonant RE. Ce transformateur fixe ou variable sert à l'adaptation du module de l'impédance de charge vue du tube électronique. Il a un coefficient de surtension très inférieur à celui du circuit résonant RE.

L'évolution de la fréquence de résonance du circuit résonant RE est contrôlée par la mesure du déphasage entre le courant fourni par le tube au circuit résonant RE et la tension aux bornes du circuit résonant RE. La composante fondamentale du courant fourni au circuit résonant a la même phase que la tension sur la grille de commande du tube électronique TE, le transformateur d'impédance TI permettant de compenser le déphasage de ¶ introduit par le tube électronique TE selon la convention de signe des courants et tensions. On peut envisager que le transformateur d'impédance TI n'ait pas cette caractéristique de compensation. Cette variante sera décrite ultérieurement. Pour plus de clarté, dans la suite immédiate de la description on suppose que le transformateur d'impédance TI compense le déphasage de ¶. Le déphasage mesuré est rendu nul par modification de la fréquence de travail de l'amplificateur à tube électronique grâce à l'oscillateur à fréquence commandée VCO. La fréquence de travail de l'amplificateur AP devient sensiblement égale à celle du circuit résonant RE.

Un diviseur de tension DC est inséré entre l'amplificateur AP et le circuit résonant RE. Ce diviseur permet de prélever une partie de la tension aux bornes du circuit résonant RE. Il est de préférence capacitif mais pourrait être inductif ou résistif.

Si le circuit résonant RE est un circuit en parallèle (comme représenté sur la figure 1) et si le courant fourni au circuit résonant RE est en avance sur la tension aux bornes du circuit résonant RE, cela signifie que la fréquence de travail du générateur est supérieure à la fréquence de résonance du circuit résonant RE. Si le circuit résonant RE était un circuit série, la fréquence de travail du générateur serait inférieure à la fréquence de résonance du circuit résonant RE.

L'écart de phase $\varnothing$ entre la tension sur la grille de commande du tube et la tension aux bornes du circuit résonant est donné par :

$$\varnothing = \text{Arctg } Q\,(w/wo - wo/w)$$

Q est le coefficient de surtension du circuit résonant RE, w la pulsation du courant fourni au circuit résonant RE, wo la pulsation à la résonance du circuit résonant RE. Les deux tensions sont en phase si w = wo.

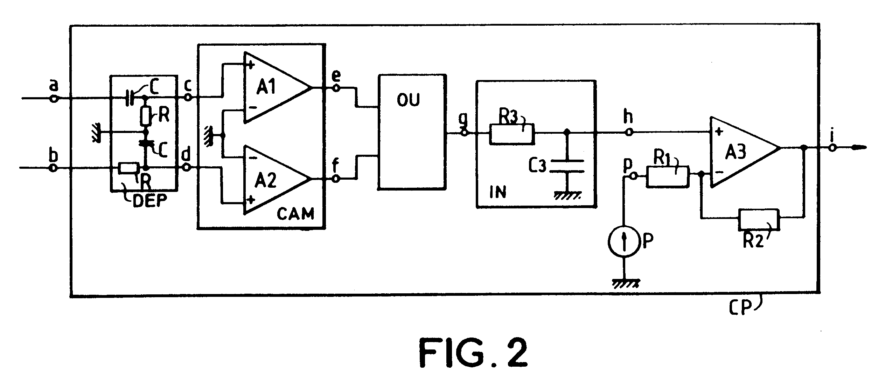

Le moyen pour mesurer le déphasage comprend un convertisseur phase-tension CP. Le convertisseur phase-tension CP est représenté sur la figure 2. Le convertisseur phase-tension est apériodique et insensible aux variations d'amplitude des tensions qui lui sont appliquées.

Les tensions présentes sur la grille de commande de la tétrode TE et aux bornes du circuit résonant RE sont appliquées respectivement sur les deux bornes a,b d'entrée du convertisseur phase-tension CP.

On suppose que la tension sur la grille de commande résonnant est en retard de to sur la tension aux bornes du circuit résonnant.

Les deux tensions peuvent s'écrire :

$$a = x \sin [(2\P/T)\,(t - to)]$$
$$b = y \sin (2\P t/T)$$

ou bien encore :

$$a = x \sin (wt + \varnothing)$$
$$b = y \sin wt$$

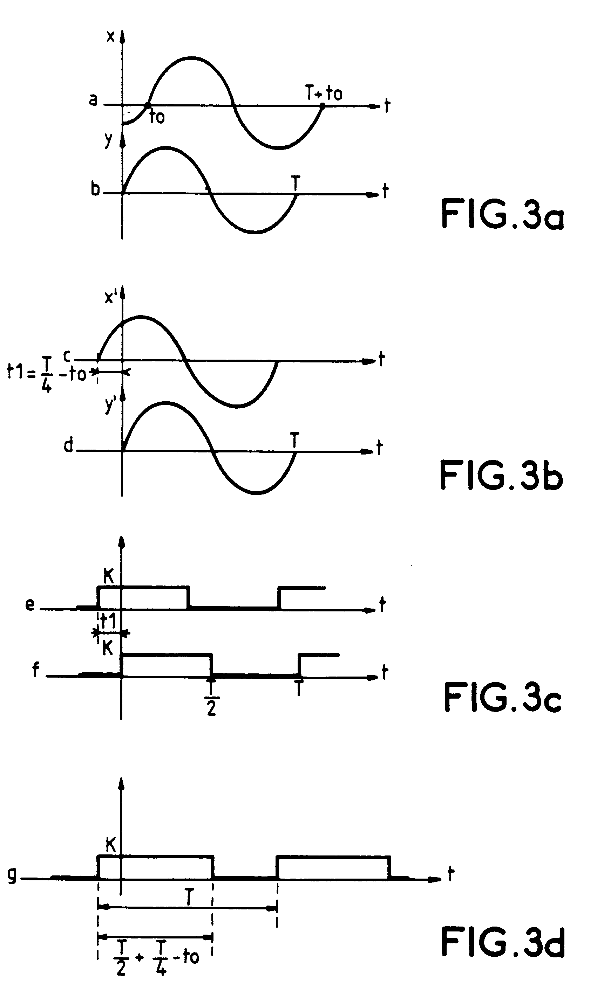

Ces deux tensions sont représentées sur la figure 3a. Le convertisseur phase-tension CP fournit à sa sortie i une tension continue d'amplitude proportionnelle à $\varnothing$ donc à to/T et indépendante des amplitudes x et y.

L'entrée du convertisseur CP phase-tension se fait sur un déphaseur DEP. Le rôle du déphaseur DEP est de maintenir une des tensions en avance de phase par rapport à l'autre, pour toutes les valeurs de l'écart de phase ∅ qui sont toujours comprises entre - ¶/2 et + ¶/2. Cette condition permet de connaître, à la sortie du convertisseur phase-tension CP, le signe de l'écart de phase ∅ entre les tensions a et b. Le déphaseur DEP reçoit sur deux entrées les tensions a et b et fournit sur deux sorties deux tensions c et d, la tension c étant en avance par rapport à la tension d pour toutes les valeurs de l'écart de phase ∅. Le déphaseur DEP introduit un déphasage supplémentaire de ¶/2 entre les tensions c et d.

$$c = x' \sin [(2\P/T) (t + T/4 - to)]$$
$$c = x' \sin [(2\P/T) (t + t1)]$$

avec $t1 = T/4 - to$

$$d = y' \sin (2\P t/T)$$

Les tensions c et d sont représentées sur la figure 3b.

Ce déphaseur DEP comporte deux réseaux R, C inversés l'un par rapport à l'autre (entrée sur la résistance pour le premier, entrée sur la capacité pour le deuxième). La tension c est en avance de phase sur la tension a d'une valeur ∅ 1 = arctg 1/RCw.

La tension d est en retard de phase sur la tension b d'une valeur ∅ 2 = -arctg RCw.

La différence de phase entre c et d est alors :

$$\emptyset + \emptyset 1 - \emptyset 2$$

avec ∅ 1 - ∅ 2 = Arctg 1/RCw + Arctg RCw, alors ∅ 1 - ∅ 2 est égal à ¶/2 quelque soit la valeur de RCw.

Un circuit amplificateur écrêteur CAM est branché à la sortie du déphaseur DEP. Ce circuit amplificateur écrêteur CAM comprend deux amplificateurs différentiels A1, A2 recevant respectivement sur leurs entrées non inverseuses les tensions c et d. Leurs entrées inverseuses sont à la masse.

Ils fournissent respectivement deux tensions e, f écrêtées, en créneaux, d'amplitude constante K. Ces créneaux ont pour durée, la demie période des tensions c et d. Les tensions e et f sont respectivement en phase avec les tensions c et d. Les créneaux correspondent à la partie positive des tensions c et d. Les tensions e et f sont représentées sur la figure 3c.

L'amplitude des tensions e et f est égale à la constante K lorsque l'amplitude des tensions c et d est positive. La tension e est en avance de t 1 = T/4 - to sur la tension f. Les tensions e et f sont appliquées sur les deux entrées d'une fonction logique. Il s'agit ici d'un circuit logique OU qui fournit sur sa sortie g, une tension qui correspond à la somme logique des tensions e et f. La durée d'un créneau est égale à T/2 + T/4 - to. La tension g est représentée sur la figure 3d.

La tension g alimente un intégrateur IN . Il s'agit d'un circuit R3, C3 dont la constante de temps est grande devant la période T. Cet intégrateur IN fournit une tension h qui correspond à la valeur moyenne de la tension g. Cette tension h varie comme l'écart de phase ∅ mais a son origine décalée de 3K/4 lorsque ∅ s'annule. La tension h est injectée sur la borne non inverseuse d'un amplificateur différentiel A3 qui reçoit sur sa borne inverseuse, une tension p d'amplitude constante, à travers une résistance R1. Il fournit la tension i. L'amplificateur A3 comporte une résistance R2 de contre-réaction entre l'entrée inverseuse et la sortie i.

La tension de sortie i de l'amplificateur A3 différentiel a pour valeur :

$$i = [(R1 + R2)/ R1].[3K/4 - Kto/T] - R2p/R1$$

En choisissant convenablement la valeur de p on peut s'affranchir de la tension de décalage 3K/4 afin que la tension i soit proportionnelle à l'écart de phase ∅.

Cette valeur convenable de p est :

$$p = (3K/4) [(R1/R2) + 1]$$

La tension i devient alors :

$$i = - [(R1 + R2)/R1] K (to/T)$$

Cette tension i est proportionnelle à -to/T donc à l'écart de phase ∅.

Lorsque le transformateur d'impédance TI ne compense pas le déphasage ¶ entre le courant fourni au circuit résonant RE et la tension sur la grille de commande du tube TE, les tensions présentes sur la grille de commande de la tétrode TE et aux bornes du circuit résonant sont respectivement :

$$a = x \sin (wt + \emptyset + \P)$$
$$b = y \sin wt$$

La tension i de sortie du convertisseur phase-tension CP devient alors :

$$i = [(R1 + R2)/R1] K (t0/T)$$

Pour rétablir le signe de la tension i il suffit d'inverser les tensions sur les entrées a et b du convertisseur CP phase-tension.

A l'équilibre, lorsque l'écart de phase ∅ s'annule, la tension sur la grille de commande du tube TE est en opposition de phase avec la tension aux bornes du circuit résonant.

Cette tension i sert à modifier la fréquence de l'oscillateur VCO. Cette tension i est injectée dans un amplificateur A4. On détermine le gain G de l'amplificateur A4 de façon à obtenir un écart de phase maximum, inférieur à une limite donnée sur toute la plage des variations de la fréquence de résonance du circuit résonant RE.

La sortie de l'amplificateur A4 alimente, à travers un interrupteur I, une première entrée j d'un sommateur S. Une deuxième entrée du sommateur S reçoit une tension I de réglage de consigne.

La tension j est égale à la tension i amplifiée lorsque l'interrupteur I est fermé. Le sommateur S fournit une tension m de commande de l'oscillateur VCO.

$$j = Gi$$
$$m = j + I$$

La tension I est ajustée en boucle ouverte (I ouvert) pour que la fréquence de l'oscillateur VCO se rapproche au maximum de la valeur théorique de la fréquence de résonance du circuit résonant RE. On effectue un préréglage de la fréquence de l'oscillateur VCO.

L'écart de phase maximum obtenu en boucle fermée dépend du gain G et des caractéristiques de l'oscillateur VCO et du convertisseur phase-tension CP.

Un générateur de chauffage, selon l'invention, a été essayé. Ces caractéristiques sont les suivantes:

. coefficient de surtension du circuit résonant :
$$Q = 60$$
. fréquence de préréglage de l'oscillateur VCO (en boucle ouverte) :
$$f' = 2\,500\ kHz$$
. fréquence de résonance du circuit résonant, à un instant donné :
$$fo = 2550\ kHz$$
. caractéristique de l'oscillateur VCO :
$$dfq/\ dV\ commande = 40,6\ kHz/V$$
autour de 2 500 kHz.
. caractéristique du convertisseur phase tension :
$$133\ mV/degré$$
. écart de phase maximum admis :
$$- 1,5° < \varnothing_{max} < + 1,5°$$

L'écart de phase correspondant en boucle ouverte (avant la correction) est de :
$$\varnothing = Arctg\ 60\ [(2500/2550 - 2550/2500)] = - 67°$$

En boucle fermée, l'écart de phase maximum admis est, dans ce cas, de -1,5°; il correspond à un écart de fréquence de - 0,5 kHz.

La fréquence f' de travail de l'amplificateur et de l'oscillateur VCO doit être de 2 549,5 kHz après correction.

La fréquence fournie par l'oscillateur VCO doit être augmentée de 49,5 kHz.

Cette augmentation correspond à une augmentation dm de la tension m :
$$dm = (49,5\ kHz.\ 1V)/40,6\ kHz = 1,22\ V$$

La tension m est issue du sommateur S et est égale à :
$$m = j + l = Gi + l$$

La tension l est constante, réglée avant l'utilisation, alors :
$$dm = Gi$$

i est la tension en sortie du convertisseur phase-tension pour un écart de phase $\varnothing$ de - 1,5°
$$i = - 1,5°.\ 133\ mV/1° = - 0,2\ V$$

Le gain G qu'il faut donner à l'amplificateur A4 est égal à :
$$G = - 1,22/0,2 = - 6,1$$

L'erreur de fréquence en boucle fermée est environ cent fois moins importante que celle obtenue sans l'asservissement.

Si le générateur selon l'invention est utilisé, par cycle de production, pour chauffer des pièces différentes ou dans le cas du chauffage par induction , s'il utilise des inducteurs différents, l'impédance de charge vue du tube est différente à chaque cycle. Afin d'optimiser le rendement du générateur on peut, avant le début du cycle, régler de façon appropriée le transformateur d'impédance TI pour être plus près des conditions d'adaptation. Le transformateur d'adaptation TI est alors variable. Le primaire du transformateur d'adaptation TI comporte généralement, au moins un élément commutable par prise, pour effectuer le préréglage.

La puissance qui sert à chauffer la pièce est fonction de la tension aux bornes du circuit résonant RE. Pour contrôler cette puissance, il suffit de contrôler l'amplitude de la tension aux bornes du circuit résonant RE.

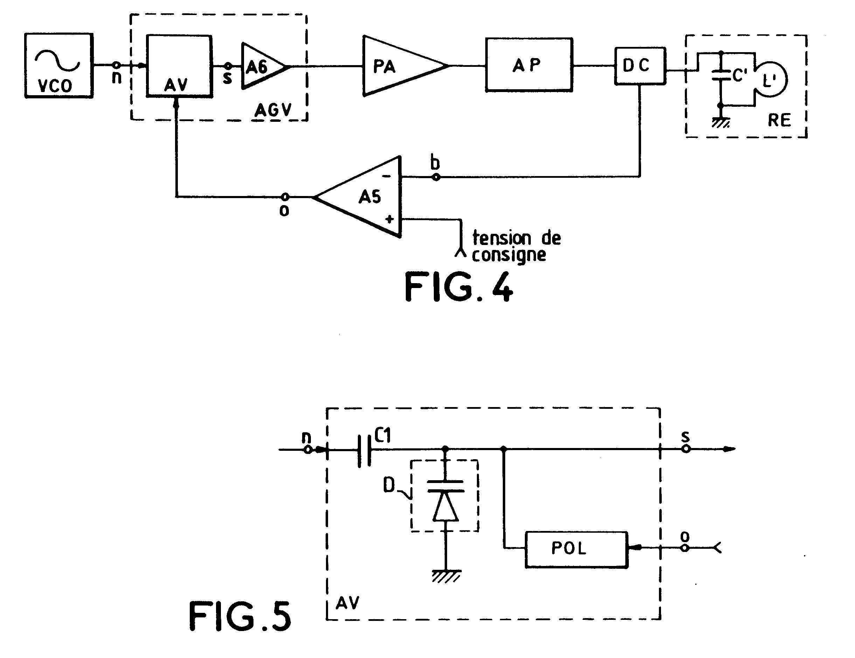

Pour cela, le générateur selon l'invention comporte aussi un élément de réglage du gain AGV entre la sortie n de l'oscillateur VCO et l'entrée de l'amplificateur AP, et une boucle d'asservissement . La boucle d'asservissement comporte un amplificateur A5 recevant sur son entrée inverseuse la tension a aux bornes du circuit résonant RE et sur son entrée non inverseuse une tension de consigne, fonction de la puissance désirée dans la pièce à chauffer. Cet élément à gain variable et cette boucle d'asservissement sont représentés sur la figure 4. L'amplificateur A5 fournit une tension de commande o à l'élément de réglage de gain AGV. Cet élement de réglage de gain est un amplificateur à gain variable.

La tension de commande o agit sur le gain de l'amplificateur à gain variable AGV dans un sens tendant à maintenir constante, à une valeur choisie, l'amplitude de la tension aux bornes du circuit résonant RE. La tension aux bornes du circuit résonant RE est asservie à la tension de consigne.

L'amplificateur à gain variable AGV comporte un atténuateur variable AV dont la sortie s est connectée à un amplificateur adaptateur d'impédance A6.

L'atténuateur variable AV est représenté sur la figure 5. Il comporte un pont diviseur capacitif (C1,D) dont une branche comporte une diode varicap D, et un circuit de polarisation POL de la diode varicap D.

L'autre branche du pont diviseur comporte une capacité C1 ayant une extrémité reliée à la sortie n de l'oscillateur VCO et l'autre extrémité reliée à la cathode de la diode varicap D. L'anode de la diode varicap D est à la masse. La sortie s de l'atténuateur variable AV se fait sur la cathode de la diode varicap D.

Le circuit de polarisation POL de la diode varicap D est branché entre la cathode de la diode varicap D et la sortie o de l'amplificateur A5. Pour une tension de polarisation donnée la diode varicap a une capacité C2.

L'impédance d'entrée de l'amplificateur A6 et la résistance du circuit de polarisation POL sont grandes devant la grandeur 1/C2.w.

L'atténuation de l'atténuateur variable est donnée par :
$$s/n = 1/[1 + (C2/C1)].$$

Elle est indépendante de w donc de la fréquence.

Les générateurs connus sont réalisés à partir d'auto-oscillateurs à tube. Les auto-oscillateurs ne sont réglables en puissance qu'en modifiant la tension d'anode. Ils nécessitent des alimentations réglables en continu, avec des dispositifs à thyristors. Ces alimentations sont très onéreuses.

Du fait que le générateur conforme à l'invention comporte un amplificateur à tube électronique, la puissance de sortie du générateur, devient réglable facilement au niveau de la tension fournie par le préamplificateur Pa et appliquée à la grille du tube. La tension d'anode n'a pas besoin d'être réglable en continue comme dans l'art antérieur.

La tension d'anode peut être fixe ou variable par commutation de plots. Si elle est commutable par plots, cela permet de maintenir le rendement sans modifier l'impédance de charge vue du tube. Cela a le même effet que le transformateur d'impédance TI commutable par prise. Dans tous les cas, le coût d'alimentation d'anode reste bien inférieur à celui d'une alimentation variable de façon continue, ce qui réduit de façon non négligeable le coût du générateur.

Le générateur de chauffage par haute fréquence décrit permet de chauffer une pièce par induction.

Il pourrait aussi être utilisé pour chauffer une pièce par pertes diélectriques. Seul le circuit résonant serait modifié. Il comprendrait au moins deux armatures entre lesquelles est placée la pièce à chauffer.

Il pourrait aussi être utilisé pour chauffer une pièce par plasma. Dans cette application le circuit résonant comprendrait une antenne d'émission.

## Revendications

1. Générateur de chauffage par haute fréquence comprenant un amplificateur (AP) dont la sortie est connectée à un circuit résonant (RE) couplé électromagnétiquement à une pièce à chauffer, et un oscillateur à fréquence commandée (VCO) fournissant un signal haute fréquence destiné à être transmis à l'entrée de l'amplificateur (AP), caractérisé en ce que l'amplificateur (AP) comprend au moins une tétrode (TE) et en ce qu'un moyen (CP,S) est prévu pour mesurer le déphasage entre le courant fourni au circuit résonant (RE) et la tension à ses bornes, et pour modifier la fréquence de l'oscillateur (VCO) en fonction de ce déphasage, le moyen étant connecté de manière à recevoir sur une entrée (a) la tension sur la grille de commande de la tétrode (TE) et sur une autre entrée (b) la tension aux bornes du circuit résonant (RE).

2. Générateur de chauffage selon la revendication 1, caractérisé en ce que le moyen pour mesurer le déphasage comprend un convertisseur phase-tension (CP) fournissant une tension (i) proportionelle à la différence de phase $\emptyset$ entre les tensions (a,b) appliquées à ses entrées.

3. Générateur de chauffage selon la revendication 2, caractérisé en ce que le convertisseur phase-tension (CP) comprend en entrée un déphaseur (DEP) pour ajouter $\P/2$ à la différence de phase $\emptyset$, ce déphaseur (DEP) fournissant deux tensions (c,d) dont la différence de phase est $\emptyset + \P/2$.

4. Générateur de chauffage selon la revendication 3, caractérisé en ce qu'un circuit amplificateur écrêteur (CAM) reçoit les tensions (c,d) déphasées de $\emptyset + \P/2$ et fournit deux tensions (e,f) logiques, en créneaux, représentant les demies périodes positives des tensions (c,d) déphasées de $\emptyset + \P/2$, à une fonction logique (OU), cette fonction logique produisant une tension (g) correspondant à la somme logique des tensions (e,f) logiques en créneaux.

5. Générateur de chauffage selon la revendication 4, caractérisé en ce qu'un amplificateur différentiel (A3) reçoit sur une entrée la tension (g) de sortie de la fonction logique (OU) après intégration, sur une autre entrée une tension constante (p) et fournit la tension (i) proportionnelle à la différence de phase $\emptyset$.

6. Générateur de chauffage selon l'une des revendications 2 à 5, caractérisé en ce que le moyen pour modifier la fréquence de l'oscillateur (VCO) en fonction du déphasage comporte un sommateur (S) qui reçoit la tension (i) de sortie du convertisseur phase tension (CP) et une tension (l) de réglage de consigne, et qui fournit une tension (m) de commande à l'oscillateur (VCO).

7. Générateur de chauffage selon l'une les revendications 1 à 6, caractérisé en ce qu'un élément de réglage de gain (AGV) est connecté entre la sortie de l'oscillateur (VCO) et l'entrée de l'amplificateur (AP) et en ce qu'une boucle d'asservissement reçoit la tension (a) aux bornes du circuit résonant (RE) et agit sur le gain de l'élément de réglage (AGV) de manière à maintenir l'amplitude de la tension aux bornes du circuit résonant (RE) sensiblement égale à une valeur choisie constante.

8. Générateur de chauffage selon la revendication 7, caractérisé en ce que la boucle d'asservissement comporte un amplificateur opérationnel (A5) recevant sur une entrée la tension aux bornes du circuit résonant (RE) et sur une autre entrée une tension de consigne fonction de la tension à obtenir aux bornes du circuit résonant (RE).

9. Générateur de chauffage selon l'une des revendications 7 ou 8, caractérisé en ce que l'élément de réglage de gain (AGV) comporte un diviseur capacitif (C1,D) dont une branche est une diode varicap (D).

10. Générateur de chauffage selon l'une des revendications 7 à 9 caractérisé en ce qu'un préamplificateur (PA) est inséré entre l'élément de réglage de gain (AGV) et l'entrée de l'amplificateur (AP).

11. Générateur de chauffage selon l'une des revendications 1 à 10, caractérisé en ce qu'un transformateur d'impédance (TI) est connecté entre la tétrode et le circuit résonant.

12. Générateur de chauffage par induction selon l'une des revendications 1 à 11, caractérisé en ce que le circuit résonant (RE) comprend au moins une boucle de circulation de courant (L') autour de la pièce à chauffer.

13. Générateur de chauffage par pertes diélectriques selon l'une des revendications 1 à 11, caractérisé en ce que le circuit résonant (RE) comprend des armatures de condensateur entre lesquelles est placée la pièce à chauffer.

14. Générateur de chauffage par plasma selon l'une des revendications 1 à 11, caractérisé en ce que le circuit résonant (RE) comprend une antenne d'émission excitant le plasma.


**Patentansprüche**

1. Hochfrequenz-Heizgenerator mit einem Verstärker (AP), dessen Ausgang mit einem elektromagnetisch mit einem zu erwärmenden Bauteil gekoppelten Schwingkreis (RE) verbunden ist, und mit einem in seiner Frequenz steuerbaren Oszillator (VCO), der ein zur Übertragung auf den Eingang des Verstärkers (AP) bestimmtes Hochfrequenzsignal liefert, dadurch gekennzeichnet, daß der Verstärker (AP) mindestens eine Tetrode (TE) aufweist und daß ein Mittel (CP, S) vorgesehen ist, um den Phasenabstand zwischen dem an den Schwingkreis (RE) gelieferten Strom und der Spannung an dessen Klemmen zu messen und um die Frequenz des Oszillators (VCO) abhängig von diesem Phasenabstand zu verändern, wobei das Mittel so angeschlossen ist, daß es an einem Eingang (a) die Spannung des Steuergitters der Tetrode (TE) und an einem anderen Eingang (b) die Spannung an den Klemmen des Schwingkreises (RE) empfängt.

2. Heizgenerator nach Anspruch 1, dadurch gekennzeichnet, daß das Mittel zur Messung des Phasenabstands einen Phasen-Spannungswandler (CP) aufweist, der eine zur Phasendifferenz $\varnothing$ den an seine Eingänge angelegten Spannungen (a, b) proportionale Spannung (i) liefert.

3. Heizgenerator nach Anspruch 2, dadurch gekennzeichnet, daß der Phasen-Spannungswandler (CP) am Eingang einen Phasenschieber (DEP) enthält, um zum Phasenabstand $\varnothing$ den Wert $\P/2$ hinzuzufügen, wobei dieser Phasenschieber (DEP) zwei Spannungen (c, d) liefert, deren Phasendifferenz den Wert $\varnothing + \P/2$ besitzt.

4. Heizgenerator nach Anspruch 3, dadurch gekennzeichnet, daß ein Verstärker (CAM) mit Spannungsbegrenzung die um $\varnothing + \P/2$ phasenverschobenen Spannungen (c, d) empfängt und zwei logische Rechtecksignale (e, f) an ein logisches Glied (OU) liefert, die die positiven Halbperioden der um $\varnothing + \P/2$ phasenverschobenen Spannungen (c, d) darstellen, wobei dieses logische Glied eine Spannung (g) entsprechend der logischen Summe der logischen Signale (e, f) erzeugt.

5. Heizgenerator nach Anspruch 4, dadurch gekennzeichnet, daß ein Differentialverstärker (A3) an einem Eingang die Ausgangsspannung (g) des logischen Gliedes (OU) nach Integration und an einem anderen Eingang eine konstante Spannung (p) empfängt und die zum Phasenabstand $\varnothing$ proportionale Spannung (I) liefert.

6. Heizgenerator nach einem der Ansprüche 2 bis 5, dadurch gekennzeichnet, daß das Mittel zur Veränderung der Frequenz des Oszillators (VCO) abhängig vom Phasenabstand ein Summierglied (S) enthält, das die Ausgangsspannung (i) des Phasen-Spannungswandlers (CP) sowie eine Sollregelspannung (1) zugeführt erhält und eine Spannung (m) zur Steuerung des Oszillators (VCO) liefert.

7. Heizgenerator nach einem der Ansprüche 1 bis 6, dadurch gekennzeichnet, daß ein Verstärkungsregelelement (AGV) zwischen den Ausgang des Oszillators (VCO) und den Eingang des Verstärkers (AP) eingefügt ist und daß eine Regelschleife die Spannung (a) an den Klemmen des Schwingkreises (RE) empfängt und den Verstärkungsgrad des Regelelements (AGV) so verändert, daß die Amplitude der Spannung an den Klemmen des Schwingkreises (RE) im wesentlichen einem gewählten konstanten Wert entspricht.

8. Heizgenerator nach Anspruch 7, dadurch gekennzeichnet, daß die Regelschleife einen Operationsverstärker (A5) enthält, der an einem Eingang die Spannung an den Klemmen des Schwingkreises (RE) und an einem anderen Eingang eine Sollspannung empfängt, die von der an den Klemmen des Schwingkreises (RE) erwünschten Spannung abhängt.

9. Heizgenerator nach einem der Ansprüche 7 oder 8, dadurch gekennzeichnet, daß das Verstärkungsregelelement (AGV) einen kapazitiven Teiler (C1, D) enthält, dessen einer Zweig eine Varicap-Diode (D) ist.

10. Heizgenerator nach einem der Ansprüche 7 bis 9, dadurch gekennzeichnet, daß ein Vorverstärker (PA) zwischen das Verstärkungsregelelement (AGV) und den Eingang des Verstärkers (AP) eingefügt ist.

11. Heizgenerator nach einem der Ansprüche 1 bis 10, dadurch gekennzeichnet, daß ein Impedanzwandler (TI) zwischen die Tetrode und den Schwingkreis eingefügt ist.

12. Induktiver Heizgenerator nach einem der Ansprüche 1 bis 11, dadurch gekennzeichnet, daß der Schwingkreis (RE) mindestens eine Schleife (L') besitzt, die einen Strom um das zu erwärmende Bauteil herumführt.

13. Generator zur Erwärmung mittels dielektrischer Verluste nach einem der Ansprüche 1 bis 11, dadurch gekennzeichnet, daß der Schwingkreis (RE) Kondensatorplatten aufweist, zwischen die das zu erwärmende Bauteil eingelegt wird.

14. Generator zur Erwärmung mittels Plasma nach einem der Ansprüche 1 bis 11, dadurch gekennzeichnet, daß der Schwingkreis (RE) eine Sendeantenne enthält, die das Plasma anregt.

**Claims**

1. High-frequency heating generator including an amplifier (AP), the output of which is connected to a resonant circuit (RE) electromagnetically coupled to a component to be heated, and a controlled-frequency oscillator (VCO) delivering a high-frequency signal intended to be transmitted to the input of the amplifier (AP), characterized in that the amplifier (AP) includes at least one tetrode (TE) and in that a means (CP,S) is provided in order to measure the phase shift between the current delivered to the resonant circuit (RE) and the voltage at its terminals, and in order to modify the frequency of the oscillator (VCO) as a function of this phase shift, the means being connected so as to receive, on an input (a), the voltage at the control gate of the tetrode (TE) and, on another input (b), the voltage at the terminals of the resonant circuit (RE).

2. Heating generator according to Claim 1, characterized in that the means to measure the phase shift includes a phase/voltage converter (CP) delivering a voltage (i) proportional to the phase difference $\varnothing$ between the voltages (a,b) applied to its inputs.

3. Heating generator according to Claim 2, characterized in that the phase/voltage converter (CP) includes, on the input side, a phase shifter (DEP) in order to add ¶/2 to the phase difference $\varnothing$, this phase shifter (DEP) delivering two voltages (c,d), the phase difference of which is $\varnothing$ + ¶/2.

4. Heating generator according to Claim 3, characterized in that a clipper amplifier circuit (CAM) receives the voltages (c,d) phase-shifted by $\varnothing$ + ¶/2 and delivers two logic square-wave voltages (e,f) representing the positive half-periods of the voltages (c,d) phase-shifted by $\varnothing$ + ¶/2, to a logic (OR) function, this logic function producing a voltage (g) corresponding to the logic sum of the logic square-wave voltages (e,f).

5. Heating generator according to Claim 4, characterized in that a differential amplifier (A3) receives, on one input, the output voltage (g) of the logic (OR) function after integration and, on another input, a constant voltage (p) and delivers the voltage (i) proportional to the phase difference $\varnothing$.

6. Heating generator according to one of Claims 2 to 5, characterized in that the means for modifying the frequency of the oscillator (VCO) as a function of the phase shift comprises an adder (S) which receives the output voltage (i) of the phase/voltage converter (CP) and a set-value adjustment voltage (1), and which delivers a control voltage (m) to the oscillator (VCO).

7. Heating generator according to one of Claims 1 to 6, characterized in that a gain control element (AGV) is connected between the output of the oscillator (VCO) and the input of the amplifier (AP) and in that a control loop receives the voltage (a) at the terminals of the resonant circuit (RE) and acts on the gain of the control element (AGV) so as to maintain the amplitude of the voltage at the terminals of the resonant circuit (RE) at substantially equal to a constant chosen value.

8. Heating generator according to Claim 7, characterized in that the control loop comprises an operational amplifier (A5) receiving, on one input, the voltage at the terminals of the resonant circuit (RE) and, on another input, a set-value voltage which is a function of the voltage to be obtained at the terminals of the resonant circuit (RE).

9. Heating generator according to either of Claims 7 and 8, characterized in that the gain control element (AGV) comprises a capacitive divider (C1,D), one arm of which is a varicap diode (D).

10. Heating generator according to one of Claims 7 to 9, characterized in that a preamplifier (PA) is inserted between the gain control element (AGV) and the input of the amplifier (AP).

11. Heating generator according to one of Claims 1 to 10, characterized in that an impedance transformer (TI) is connected between the tetrode and the resonant circuit.

12. Induction-heating generator according to one of Claims 1 to 11, characterized in that the resonant circuit (RE) includes at least one current circulation loop (L') around the component to be heated.

13. Dielectric-loss heating element according to one of Claims 1 to 11, characterized in that the resonant circuit (RE) includes capacitor plates between which the component to be heated is placed.

14. Plasma-heating generator according to one of Claims 1 to 11, characterized in that the resonant circuit (RE) includes an emission antenna that excites the plasma.

FIG. 1

sens des courants positifs

VCO

AGV

PA

AP

TE

Ti

DC

RE

C'

L'

A5

CP

S +

A4

tension
de réglage

tension
de consigne

EP 0 495 699 B1

FIG. 2

FIG.3a

FIG.3b

FIG.3c

FIG.3d

FIG. 4

FIG. 5

EP 0 495 699 B1